# EUROPÄISCHE PATENTANMELDUNG

(11) **EP 2 520 454 A2**
(43) Veröffentlichungstag der Anmeldung: **07.11.2012**
(21) Anmeldenummer: 12164075.9
(22) Anmeldetag: 13.04.2012
(51) Int. Cl.: B60L 11/00

(54) **Elektrischer Energiespeicher für Fahrzeug mit elektrischem Antrieb**

(30) Priorität: 02.05.2011 DE 102011100180
(71) Anmelder: STILL GmbH, 22113 Hamburg (DE)
(72) Erfinder: Wilhöft, Adolf, 22885 Barsbüttel (DE); Schettgen, Nils, 22858 Barsbüttel (DE)
(74) Vertreter: Geirhos, Johann

(57) **Zusammenfassung**

Bei einem elektrischer Energiespeicher für ein Fahrzeug mit zumindest auch elektrischem Antrieb, insbesondere Hybridantrieb, wobei der elektrische Energiespeicher (17) eine Mehrzahl von Ultrakondensatoren (35) aufweist, sind mehrere Ultrakondensatoren (35) auf einer gemeinsamen Leiterplatte (41) angeordnet und wird die Leiterplatte (41) über die Ultrakondensatoren (35) durch Anpressmittel mit der den Ultrakondensatoren (35) abgewandten Seite über eine erste elastische Zwischenschicht (45) gegen eine Gehäusewand (46) gedrückt. Anschlüsse (43) der Ultrakondensatoren (35) ragen durch die Leiterplatte (41) hindurch in die erste elastische Zwischenschicht (45) und die erste elastische Zwischenschicht (45) weist eine hohe Wärmeleitfähigkeit zur Ableitung der Verlustwärme der Ultrakondensatoren (35) an die Gehäusewand (46) auf.

## Beschreibung

Die Erfindung betrifft einen elektrischen Energiespeicher für ein Fahrzeug mit zumindest auch elektrischem Antrieb, insbesondere Hybridantrieb, wobei der elektrische Energiespeicher eine Mehrzahl von Ultrakondensatoren aufweist.

Zur Speicherung von elektrischer Energie sind aus mehreren in Reihe geschalteten Speicherzellen, insbesondere Ultra- oder Doppelschichtkondensatoren, bestehende Energiespeicher bekannt. Diese Energiespeicher besitzen eine hohe Energie- und Leistungsdichte, so dass hohe Lade-, wie auch Entladeströme möglich sind.

Insbesondere bei verbrennungsmotorisch betriebenen Flurförderzeugen mit elektrischer Leistungsübertragung für den Fahrantrieb, bei der ein von dem Verbrennungsmotor, z.B. einem Dieselmotor, angetriebener Generator einen elektrischen Zwischenkreis speist, aus dem wiederum ein Fahrantriebsmotor gespeist wird, können solche Energiespeicher eingesetzt werden, um ein Hybridfahrzeug zu bilden. Es wird dann bei hohem Leistungsbedarf zusätzlich zu dem Verbrennungsmotor zur Versorgung des Fahrantriebsmotors Energie dem Energiespeicher entnommen und andererseits Energie beim elektrischen Bremsen in den Energiespeicher eingespeist, anstatt diese Energie über einen Bremswiderstand ungenutzt in Wärme umzusetzen. Der Verbrennungsmotor kann dann entsprechend in der Leistung kleiner ausgelegt werden. Durch den schnellen Wechsel zwischen Laden und Entladen des Energiespeichers und die hohen Ströme entstehen jedoch unvermeidlich relativ hohe Verlustleistungen und die Speicherzellen sowie deren Leistungsanschlüsse erwärmen sich.

Als Doppelschichtkondensatoren zum Aufbau des Energiespeichers werden beispielsweise unter der Bezeichnung Ultracaps bekannte Doppelschichtkondensatoren als einzelne Speicherzellen eingesetzt, die sich bis zu einer Spannung von ca. 2,5 V aufladen lassen und aus denen Module mit mehreren in Reihe geschalteten Speicherzellen gebildet werden. Hierbei sind Bauformen von Speicherzellen bekannt, die an einer Stirnseite eines beispielsweise zylindrischen oder quaderförmigen Grundkörpers elektrische, zumeist zylinderförmige Anschlüsse aufweisen. Auf diese Anschlüsse können Kupferschienen aufgeschrumpft, geschraubt oder geschweißt werden, um die Speicherzellen elektrisch anzuschließen. Auch sind solche Anschlussschienen aufwändig und verursachen höhere Kosten.

Nachteilig hieran ist, dass dies zumindest zum Teil Spezialwerkzeuge erfordert. Da die Speicherzellen keine weiteren mechanischen Befestigungspunkte haben, gestaltet sich die mechanische Halterung der Speicherzellen im Verbund aufwändig. Gerade bei einem Einsatz in einem Flurförderzeug, das im Regelfall keine Federung des Fahrwerks besitzt, entstehen jedoch im Betrieb Erschütterungen, die eine sichere Halterung der relativ schweren Speicherzellen in einem Gehäuse erfordern. Um Beschädigungen durch Schwingungen zu vermeiden ist dabei sogar wünschenswert, dass die Befestigung der Speicherzellen energieaufnehmende Dämpfungseigenschaften hat.

Nachteilig an diesem Stand der Technik ist auch, dass bei diesem äußeren Aufbau der Speicherzellen eine thermische Anbindung der Speicherzellen an eine Gehäusewand, um die Verlustwärme abzuführen und die Speicherzellen zu kühlen, nur schwer zu verwirklichen ist. Aufgrund der fehlenden thermischen Anbindung müssen dann aber teure Zellen eingesetzt werden, um die geforderten Lebensdauer bzw. Zyklenzahl auch bei einem Betrieb unter hohen Temperaturen zu erreichen.

Weiterhin ist es auch erforderlich, die einzelnen Speicherzellen in Bezug auf einen symmetrischen Ladezustand zu überwachen. Dies erfordert eine Messleitung an jede Speicherzelle zur Verbindung mit der dazu gehörenden Überwachungselektronik. Bei höherer Zellenzahl pro Speichermodul entsteht dadurch eine Art Kabelbaum in dem alle Messleitungen zur Überwachungselektronik geführt werden. Alternativ kann auch eine Leiterplatte mit einer Überwachungselektronik für jede Speicherzelle eingesetzt werden. Dies führt jedoch zu Platzproblemen und zu einer sehr aufwändigen Montage, da alle Messleitungen angeschlossen werden müssen.

Der vorliegenden Erfindung liegt daher die Aufgabe zugrunde, einen elektrischen Energiespeicher für ein Fahrzeug mit zumindest auch elektrischem Antrieb, insbesondere Hybridantrieb, zur Verfügung zu stellen, der die zuvor genannten Nachteile vermeidet und einfach sowie kostengünstig herzustellen ist.

Diese Aufgabe wird durch einen elektrischer Energiespeicher für ein Fahrzeug mit zumindest auch elektrischem Antrieb, insbesondere Hybridantrieb, mit den Merkmalen des unabhängigen Anspruchs 1 sowie ein Fahrzeug mit zumindest auch elektrischem Antrieb, insbesondere Hybridantrieb, mit den Merkmalen des Anspruchs 12 gelöst. Vorteilhafte Weiterbildungen werden in den Unteransprüchen angegeben.

Die Aufgabe wird durch einen elektrischer Energiespeicher für ein Fahrzeug mit zumindest auch elektrischem Antrieb gelöst, insbesondere Hybridantrieb, wobei der elektrische Energiespeicher eine Mehrzahl von Ultrakondensatoren aufweist, mehrere Ultrakondensatoren auf einer gemeinsamen Leiterplatte angeordnet sind, die Leiterplatte über die Ultrakondensatoren durch Anpressmittel mit der den Ultrakondensatoren abgewandten Seite über eine erste elastische Zwischenschicht gegen eine Gehäusewand gedrückt wird und Anschlüsse der Ultrakondensatoren durch die Leiterplatte hindurch in die erste elastische Zwischenschicht ragen sowie die erste elastische Zwischenschicht eine hohe Wärmeleitfähigkeit zur Ableitung der Verlustwärme der Ultrakondensatoren an die Gehäusewand aufweist.

Dadurch wird eine kostengünstige Fertigung ermöglicht. Der elektrische Energiespeicher mit seiner Mehrzahl an auf einer Leiterplatte angeordneten Ultrakondensatoren bildet ein Speichermodul. Die hierfür verwendeten Kondensatoren können Lötanschlüsse aufweisen, so dass ein kostengünstiger Lötprozess, beispielsweise ein Wellenlötprozess, für die Montage der Ultrakondensatoren auf der Leiterplatte verwendet werden kann. Die durch die zyklische Ladung und Entladung in den Speicherzellen bzw. Ultrakondensatoren entstehende Verlustleistung kann durch die flächige, unterhalb der Leiterplatte angeordnete elastische und wärmeleitfähige Zwischenschicht über die Kondensatorlötanschlüsse nach unten in eine Gehäusewand, beispielsweise einen Gehäuseboden des Gehäuses, abgeführt werden. Dadurch wird der Einsatz kostengünstiger Kondensatoren möglich, die zwar weniger günstige elektrische Eigenschaften haben, aber durch die gute Kühlung die geforderte Lebensdauer dennoch erreichen.

In günstiger Ausführungsform bestehen die Anpressmittel aus einer Abstützung der Ultrakondensatoren über eine zweite elastische und wärmeleitfähige Zwischenschicht gegen eine gegenüberliegende Gehäusewand.

Durch die zweite elastische Zwischenschicht wird der thermische und mechanische Kontakt zur thermisch leitfähigen gegenüberliegenden Gehäusewand, beispielsweise einem Gehäusedeckel des Gehäuses, sicherstellt. Dadurch sind die Ultrakondensatoren zusammen mit der Leiterplatte zwischen zwei elastischen Zwischenschichten eingespannt und auf einfache und dennoch zuverlässige Weise mechanisch fixiert, wobei der mechanische Anpressdruck zugleich eine gute Wärmeübertragung sicherstellt. Durch die Elastizität der Zwischenschichten wird auch eine gute Schwingungsdämpfung erreicht. Durch das relativ hohe Gewicht der Speicherzellen sind diese unter Schock- oder Schwingungsbelastung großen Kräften ausgesetzt, die durch die erfindungsgemäße Ausführungsform gut aufgenommen werden können. Eine aufwendige mechanische Befestigung der Ultrakondensatoren wird durch die Einspannung zwischen den elastischen Zwischenschichten entbehrlich.

Vorteilhaft weist ein zugehöriges Gehäuse Kühlrippen auf, insbesondere in einem Bereich einer Gehäusewand, an der die erste oder zweite elastische Zwischenschicht anliegt.

Die Kühlrippen gewährleisten einen guten thermischen Fluss an die Umgebung.

In günstiger Ausgestaltung der Erfindung liegt die erste elastische Zwischenschicht im Wesentlichen vollflächig an der Leiterplatte an.

Die Leiterplatte erwärmt sich aufgrund der nicht vermeidbaren ohmschen Widerstände der Leiterbahnen. Die entstehende Wärme wird durch die im Wesentlichen vollflächig an der Leiterplatte anliegende Zwischenschicht in die Gehäusewand, beispielsweise den Gehäuseboden des Gehäuses, abgeführt. Dadurch ist der Einsatz von dünnerem Kupfer in den Leiterbahnen möglich und eine entsprechende Kostenersparnis aufgrund des geringeren Materialverbrauchs.

Die erste und/oder zweite elastische Zwischenschicht kann aus einem Wärmeleitpad bzw. mehreren einzelnen Wärmeleitpads bestehen.

Ein Wärmeleitpad kann als flächiges Material oder als eine Art Folie bei der Produktion in das Gehäuse gelegt werden und muss nicht aufgetragen oder verteilt werden. Dadurch wird die Fertigung vereinfacht. Insbesondere auf der Oberseite der Ultrakondensatoren kann auch auf jedem Ultrakondensator einzeln je ein Wärmeleitpad angebracht werden. Dabei ist die Elastizität des Wärmeleitpad so ausgelegt, dass die Anschlüsse der Speicherzellen, zumeist Metalldrähte zur Verlötung, sich in das Material des Wärmeleitpads drücken können, ohne dass das Wärmeleitpad in diesem Bereich sich von der Leiterplatte abhebt.

Vorteilhaft besteht das Wärmeleitpad aus einem Silikonmaterial.

Dieses Silikonmaterial kann mit wärmeleitenden Materialien gemischt sein.

Die erste und/oder zweite elastische Zwischenschicht kann aus einem isolierenden Material bestehen.

Dadurch wird die Notwendigkeit einer zusätzlichen Isolierschicht oder eines Überziehens der Kontakte der Ultrakondensatoren und der Leiterbahnen der Leiterplatte mit einer Isolierschicht vermieden, beispielsweise einem Isolierlack.

In günstiger Ausführungsform ist die Leiterplatte durch Führungselemente gegen Bewegungen in der Ebene der Gehäusewand gesichert.

Das Gehäuse kann beispielsweise Führungsschienen als Führungselemente aufweisen, die ein Verrutschen der Leiteplatte in einer oder zwei Richtungen, entsprechend einer X-Y-Ebene parallel zu der Gehäusewand verhindern. Die elastischen Zwischenschichten verhindern ein Schwingen der Ultrakondensatoren in Z-Richtung.

Vorteilhaft bestehen die Führungselemente aus durch Öffnungen in der Leiterplatte greifende Bolzen.

Die Ultrakondensatoren können Doppelschichtkondensatoren sein.

In günstiger Ausführungsform sind auf der Leiterplatte auch Messleitungen zu den Ultrakondensatoren und/oder Elemente einer Steuer- und/oder Überwachungselektronik und/oder eine Leistungselektronik angeordnet.

Die Speicherzellen und die dazu gehörende Überwachungs-/ Steuerungs- und Leistungselektronik befinden sich somit auf einer gemeinsamen Leiterplatte. Dadurch ist der Einsatz von Messkabeln zwischen den Speicherzellen und der Elektronik nicht notwendig. Die Überwachungselektronik kann sich direkt zwischen bzw. unter den Speicherzellen bzw. Ultrakondensatoren befinden. Die Leistungselektronik und die Steuerungselektronik können sich bevorzugt neben den Ultrakondensatoren auf der gemeinsamen Leiterplatte befinden.

Die Aufgabe wird auch durch ein Fahrzeug mit zumindest auch elektrischem Antrieb, insbesondere Hybridantrieb, mit einem zuvor beschriebenen elektrischen Energiespeicher für die Speicherung von elektrischer Energie gelöst, insbesondere von Rekuperationsenergie wie etwa beim elektrischen Bremsen entstehender elektrischer Energie.

Das Fahrzeug weist die bereits zuvor beschriebenen Vorteile auf.

Das Fahrzeug ist vorteilhaft ein Flurförderzeug.

Gerade bei einem Flurförderzeug kommen die Vorteile des erfindungsgemäßen Energiespeichers besonders zum Tragen, da durch das häufige Beschleunigen und Abbremsen ein Hybridantrieb besondere Vorteile hat.

Weitere Vorteile und Einzelheiten der Erfindung werden anhand des in den schematischen Figuren dargestellten Ausführungsbeispiels näher erläutert. Hierbei zeigt
- Fig. 1: einen verbrennungsmotorisch-elektrischen Antriebsstrang für ein als Flurförderzeug ausgebildetes Fahrzeug mit einem erfindungsgemäßen elektrischen Energiespeicher in einer schematischen Darstellung,
- Fig. 2: eine schematische Darstellung des verbrennungsmotorisch-elektrischen Antriebsstrang für das Fahrzeug der Fig. 1,
- Fig. 3: eine schematische Schnittansicht eines erfindungsgemäßen elektrischen Energiespeichers aus der Fig. 1,
- Fig. 4: eine schematische Aufsicht auf eine Leiterplatte des elektrischen Energiespeichers der Fig. 1 und
- Fig. 5: ein Schaltbild des elektrischen Energiespeichers.

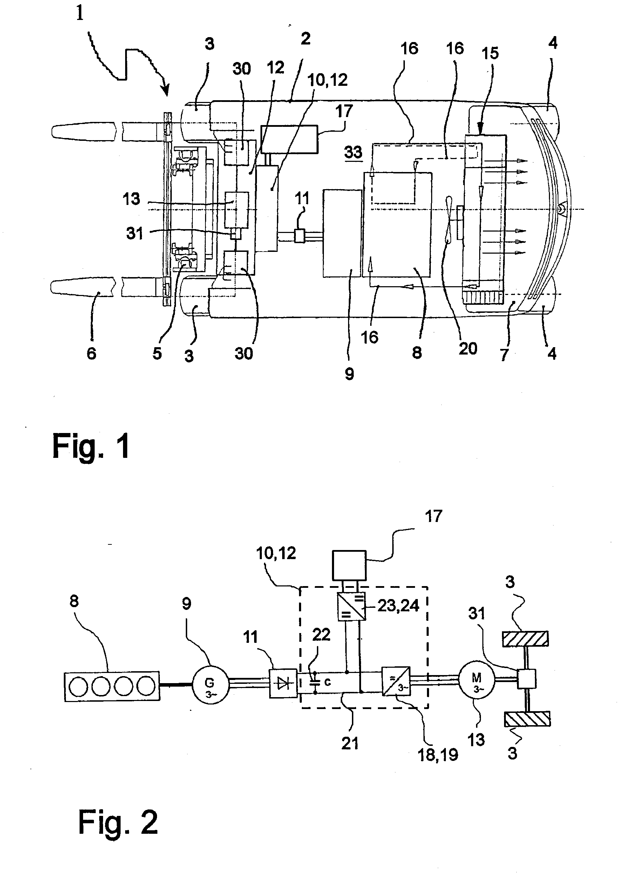

In der Fig. 1 ist ein verbrennungsmotorisch-elektrisch angetriebenes Flurförderzeug 1 in Form eines Gegengewichtsgabelstaplers als Beispiel eines Fahrzeugs mit zumindest auch elektrischem Antrieb in einer Aufsicht mit den wesentlichen Aggregaten des Antriebs dargestellt, bei dem ein erfindungsgemäßer elektrische Energiespeicher 17 eingesetzt wird.

Das Flurförderzeug 1 weist einen Fahrzeugrahmen 2 auf, der im lastzugewandten Bereich mit zwei Antriebsrädern 3 und im lastabgewandten Bereich mit gelenkten Rädern 4 versehen ist. Am vorderen lastzugewandten Bereich des Flurförderzeugs 1 ist ein Hubgerüst 5 angeordnet, an dem ein als Lastgabel ausgebildetes Lastaufnahmemittel 6 auf- und abbewegbar angeordnet ist. Im lastabgewandten Bereich ist das Flurförderzeug 1 mit einem Gegengewicht 7 versehen.

Das Flurförderzeug 1 ist mit einem verbrennungsmotorisch-elektrischen Antriebssystem versehen, das ein elektrisches Fahrantriebsaggregat umfasst. Das Fahrantriebsaggregat weist eine Energieversorgungseinheit auf, die von einem Verbrennungsmotor 8, z.B. einem Dieselmotor, und einem mit dem Verbrennungsmotor 8 verbundenen und angetriebenen Synchrongenerator 9 gebildet ist.

Die von dem Synchrongenerator 9 erzeugte elektrische Energie wird über einen Gleichrichter 11 der in einem Gehäuse 12 integrierten Leistungselektronik 10 zugeführt, mittels der mindestens ein in oder an einer Antriebsachse 14 angeordneten elektrischer Fahrantriebsmotor 13, beispielsweise ein Asynchrondrehstrommotor, mit elektrischer Energie versorgt wird.

Der Fahrantriebsmotor 13 steht unter Zwischenschaltung eines Differentialgetriebes 31 und zweier Untersetzungsgetrieben 30 mit den Antriebsrädern 3 in Verbindung. Anstelle einer derartigen Einmotorachse, bei der ein Fahrantriebsmotor 13 beide Antriebsräder 3 antreibt, kann auch eine Zweimotorachse vorgesehen werden, bei der jeweils ein Fahrantriebsmotor unter Zwischenschaltung eines Untersetzungsgetriebes mit dem entsprechenden Antriebsrad 3 in Verbindung steht.

Der Verbrennungsmotor 8, der Generator 9 sowie das Gehäuse 12 und die Antriebsachse 14 sind hierbei zusammen mit weiteren nicht mehr dargestellten Komponenten in einem Aggregateraum 33 des Flurförderzeugs 1 angeordnet.

Der Verbrennungsmotor 8 ist mit einer Flüssigkeitskühlung versehen. Die Flüssigkeitskühlung weist einen beispielsweise im Bereich des Gegengewichts 7 angeordneten Wärmetauscher 15 auf, der mit dem Verbrennungsmotor 8 in Kühlkreisläufen 16 verbunden ist. Der Wärmetauscher 15 wird mit Hilfe eines Kühllüfters 20 von Luft durchströmt, um die von der Kühlflüssigkeit an die Umgebungsluft abgebbare Wärmemenge zu erhöhen.

Mit der Leistungselektronik 12 ist der elektrische Energiespeicher 17 verbunden. Das Flurförderzeug 1 ist ein Hybridfahrzeug, bei dem beim Bremsen über den Fahrantriebsmotor 13 Strom erzeugt wird, der in dem elektrischen Energiespeicher 17 gespeichert wird und z.B. bei großem Leistungsbedarf zusätzlich zu dem durch den Verbrennungsmotor 8 und den Synchrongenerator 9 erzeugten Strom dem Fahrantriebsmotor 13 über die Leistungselektronik 10 zugeführt wird. Dadurch kann der Verbrennungsmotor 8 kleiner ausgelegt werden und dennoch eine große Leistung z.B. beim kurzzeitigen Beschleunigen des Flurförderzeugs 1 erreicht werden.

Fig. 2 zeigt schematisch den Aufbau des Antriebssystems des Flurförderzeugs 1 aus der Fig. 1. Der Verbrennungsmotor 8 treibt den als Synchrongenerator ausgebildeten Generator 9 an und der von dem Generator 9 erzeugte Drehstrom wird in dem Gleichrichter 11 gleichgerichtet und der in dem Gehäuse 12 angeordneten Leistungselektronik 10 zugeführt. Ein Wechselrichter 18 als erster Umrichter 19 bildet aus der Gleichspannung des als Gleichspannungs-Zwischenkreis ausgebildeten Zwischenkreises 21 dreiphasigen Drehstrom variabler Frequenz, mit dem der Fahrantriebsmotor 13 gespeist wird, der über das Differentialgetriebe 31 die Antriebsräder 3 antreibt. Ein im Gehäuse 12 angeordneter Kondensator 22 dient als Eingangsfilter, der gleichzeitig auch den Eingangsfilter eines Gleichspannungswandlers 23 bildet, der als zweiter Umrichter 24 in das Gehäuse 12 integriert ist und den elektrischen Energiespeicher 17 anschließt.

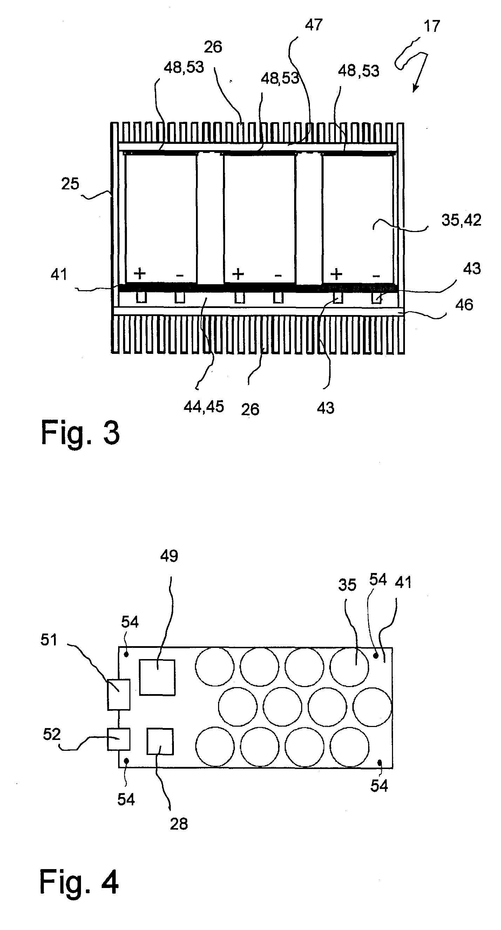

Die Fig. 3 zeigt in einer schematischen Schnittansicht den elektrischen Energiespeicher 17. In einem Gehäuse 25 sind alle beschriebenen Komponenten und Bestandteile des elektrischen Energiespeichers zusammengefasst. Das Gehäuse 25 weist an seiner Oberseite wie auch Unterseite Kühlrippen 26 auf. Auf einer Leiterplatte 41 sind Ultrakondensatoren 35 als Speicherzellen 42 angeordnet, die über Lötanschlüsse 43 mit der Leiterplatte 41 verlötet sind. Die Anschlüsse 43 ragen durch Bohrungen in der Leiterplatte 41 hindurch in eine als Wärmeleitpad 44 ausgebildete erste elastische und wärmeleitfähige Zwischenschicht 45, mit der die Leiterplatte 41 gegen eine Gehäusewand 46, beispielsweise einen Gehäuseboden des Gehäuses, gedrückt wird, so dass die Verlustwärme der Ultrakondensatoren 35 von den Anschlüssen 43 über den Wärmeleitpad 44 und die Gehäusewand 46 an die Kühlrippen 26 abgegeben wird. Eine gegenüber liegende Gehäusewand 47 übt über eine ebenfalls als Wärmeleitpad 48 ausgebildete, bzw. aus mehren Wärmeleitpads 48 bestehende, zweite elastische und wärmeleitfähige Zwischenschicht 53 den Anpressdruck aus und spannt die Ultrakondensatoren 35 so ein, dass diese schwingungsgedämpft gehalten werden und zugleich über die gegenüber liegende Gehäusewand 47, beispielsweise einen Gehäusedeckel des Gehäuses, und den Wärmeleitpad 48 ebenfalls Verlustwärme ableiten können. Dabei liegt der die erste elastische Zwischenschicht 45 bildende Wärmeleitpad 44 im Wesentlichen vollflächig an der Leiterplatte 41 an und kühlt somit auch die Leiterbahnen auf der Leiterplatte 41, deren Kupferdicke entsprechend geringer dimensioniert werden kann.

Die Fig. 4 zeigt in schematische Aufsicht die Leiterplatte 41 des elektrischen Energiespeichers 17, mit den Ultrakondensatoren 35. Auf der Leiterplatte 41 sind auch eine Steuer- und/oder Überwachungselektronik 49 sowie ein Schütz 28 als Komponente einer Leistungselektronik angeordnet. Ebenfalls sind auf der Leiterplatte 41 noch eine Steuersteckverbindung 51 und eine Leistungssteckverbindung 52 angeordnet. Durch Öffnungen in der Leiterplatte 41 greifende Bolzen 54 verhindern, dass die Leiterplatte 41 in der X-Y-Ebene der Gehäusewand 46 sich bewegen kann, während die Einspannung der Ultrakondensatoren 35 über die erste Gehäusewand 46 und zweite Gehäusewand 47 eine Bewegung senkrecht zu der Leiterplatte in der Z-Ebene verhindert.

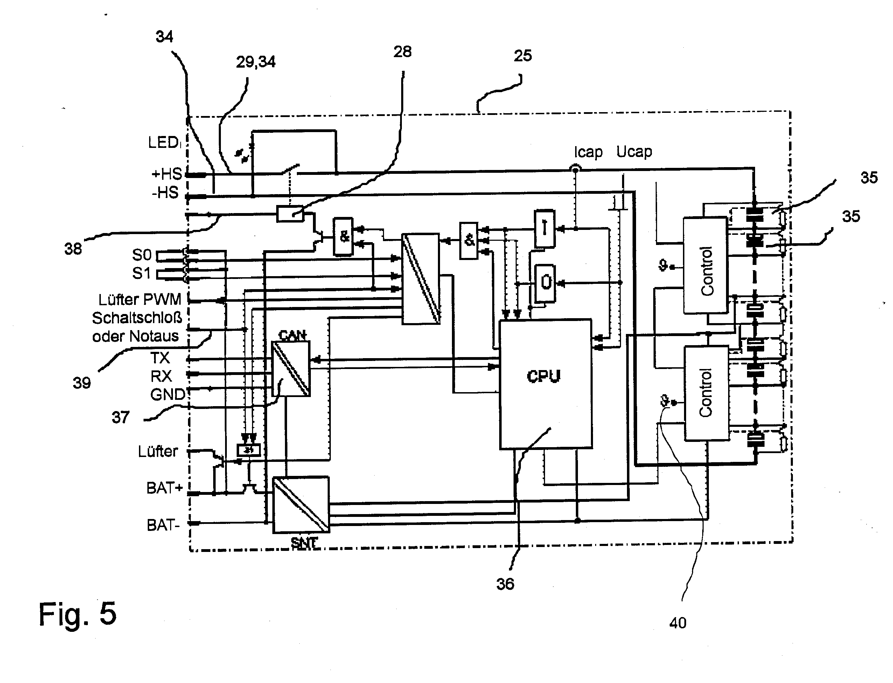

Die Fig. 5 zeigt ein Schaltbild des elektrischen Energiespeichers 17. Ein Schütz 28 kann die Plusleitung 29 von Leistungsanschlüssen 34 unterbrechen. Einheiten von Ultrakondensatoren 35 sind in Reihe geschaltet. Temperaturen der Ultrakondensatoren 34 werden einem Controller 36 zugeführt, der über einen CAN-Buscontroller 37 mit einer Fahrzeugsteuerung verbunden ist und Informationen über den Betriebszustand des elektrischen Energiespeichers 17 mit dieser austauschen kann. Über eine Signalleitung 38 kann der Schütz 28 von einem Schaltschloss bzw. Zündschloss oder einem Notausschalter freigegeben werden, so dass der Schütz 28 nur einschalten kann, wenn dieses Signal vorliegt. Daneben kann über eine weitere Datenleitung 39 eine Betätigung des Schütz 28 durch das Schaltschloss oder den Notausschalter erfolgen. Es ist natürlich auch möglich, die Funktionen der Freigabe und des Schaltens des Schütz 28 nur über eine Datenleitung umzusetzen. Der Energiespeicher 17 ist weiterhin mit einer Gesamtspannungsmessung U_{cap} und einer Strommessung I_{cap} durch den Controller 36 versehen. Zur Temperaturüberwachung des Energiespeichers 17 sind mehrere Temperaturensensoren 40 vorgesehen, die mit dem Controller 36 in Verbindung stehen und gleichmäßig im Energiespeicher 17 verteilt sind.

Der Controller 36, der ein Teil der in Fig. 4 beschriebenen Steuer- und/oder Überwachungselektronik 49 bildet, kann weiterhin die Ausgleichsschaltung jedes Ultrakondensators 35 zu- oder abschalten. Dadurch können beliebige Betriebsstrategien gefahren werden, die der Symmetrierung und der gleichmäßigen Alterung der Ultrakondensatoren 34 dient.

Durch den integrierten Schütz 28 wird ermöglicht, dass der Energiespeicher 17 bei Kurzschlüssen und/oder grenzwertüberschreitenden Spannungen oder Strömen durch eine Zwangsöffnung des Schütz 28 von dem Fahrzeug getrennt werden kann.

Die in der Fig. 5 dargestellten Komponenten der Steuer- und/oder Überwachungselektronik 49 sowie der Schütz 28 als Leistungselektronik sind zusammen mit den Ultrakondensatoren 35 auf der gemeinsamen Leiterplatte 41 angeordnet, wodurch eine einfache Verbindung zwischen den Ultrakondensatoren 35 und der Steuer- und/oder Überwachungselektronik 49 sowie der Leistungselektronik erzielt wird.

## Patentansprüche

1. Elektrischer Energiespeicher für ein Fahrzeug mit zumindest auch elektrischem Antrieb, insbesondere Hybridantrieb, wobei der elektrische Energiespeicher (17) eine Mehrzahl von Ultrakondensatoren (35) aufweist,
**dadurch gekennzeichnet,**
**dass** mehrere Ultrakondensatoren (35) auf einer gemeinsamen Leiterplatte (41) angeordnet sind, die Leiterplatte (41) über die Ultrakondensatoren (35) durch Anpressmittel mit der den Ultrakondensatoren (35) abgewandten Seite über eine erste elastische Zwischenschicht (45) gegen eine Gehäusewand (46) gedrückt wird und Anschlüsse (43) der Ultrakondensatoren (35) durch die Leiterplatte (41) hindurch in die erste elastische Zwischenschicht (45) ragen sowie die erste elastische Zwischenschicht (45) eine hohe Wärmeleitfähigkeit zur Ableitung der Verlustwärme der Ultrakondensatoren (35) an die Gehäusewand (46) aufweist.

2. Elektrischer Energiespeicher nach Anspruch 1,
**dadurch gekennzeichnet,**
**dass** die Anpressmittel aus einer Abstützung der Ultrakondensatoren (35) über eine zweite wärmeleitfähige Zwischenschicht (53) gegen eine gegenüberliegende Gehäusewand (47) bestehen.

3. Elektrischer Energiespeicher nach Anspruch 1 oder 2,
**dadurch gekennzeichnet,**
**dass** ein zugehöriges Gehäuse (25) Kühlrippen (26) aufweist, insbesondere in einem Bereich einer Gehäusewand (46,47) an der die erste oder zweite elastische Zwischenschicht (45,53) anliegt.

4. Elektrischer Energiespeicher nach einem der Ansprüche 1 bis 3,
**dadurch gekennzeichnet,**
**dass** die erste elastische Zwischenschicht (45) im Wesentlichen vollflächig an der Leiterplatte (41) anliegt.

5. Elektrischer Energiespeicher nach einem der Ansprüche 1 bis 4,
**dadurch gekennzeichnet,**
**dass** die erste und/oder zweite elastische Zwischenschicht (45,53) aus einem Wärmeleitpad (44) besteht bzw. mehreren einzelnen Wärmeleitpads (48) bestehen.

6. Elektrischer Energiespeicher nach Anspruch 5,
**dadurch gekennzeichnet,**
**dass** das Wärmeleitpad (44,48) aus einem Silikonmaterial besteht.

7. Elektrischer Energiespeicher nach einem der Ansprüche 1 bis 6,
**dadurch gekennzeichnet,**
**dass** die erste und/oder zweite elastische Zwischenschicht (44,48) aus einem isolierenden Material besteht.

8. Elektrischer Energiespeicher nach einem der Ansprüche 1 bis 7,
**dadurch gekennzeichnet,**
**dass** die Leiterplatte (41) durch Führungselemente gegen Bewegungen in der Ebene der Gehäusewand (46) gesichert ist.

9. Elektrischer Energiespeicher nach Anspruch 8,
**dadurch gekennzeichnet,**
**dass** die Führungselemente aus durch Öffnungen in der Leiterplatte (41) greifende Bolzen (54) bestehen.

10. Elektrischer Energiespeicher nach einem der Ansprüche 1 bis 9,
**dadurch gekennzeichnet,**
**dass** die Ultrakondensatoren (35) Doppelschichtkondensatoren sind.

11. Elektrischer Energiespeicher nach einem der Ansprüche 1 bis 10,
**dadurch gekennzeichnet,**
**dass** auf der Leiterplatte (41) auch Messleitungen zu den Ultrakondensatoren (35) und/oder Elemente der Steuer- und/oder Überwachungselektronik (49) und/oder einer Leistungselektronik angeordnet sind.

12. Fahrzeug mit zumindest auch elektrischem Antrieb, insbesondere Hybridantrieb, mit einem elektrischen Energiespeicher (17) nach einem der Ansprüche 1 bis 11 für die Speicherung von elektrischer Energie, insbesondere von Rekuperationsenergie wie etwa beim elektrischen Bremsen entstehender elektrischer Energie.

13. Fahrzeug nach Anspruch 12,
**dadurch gekennzeichnet,**
**dass** das Fahrzeug ein Flurförderzeug (1) ist.
